# EUROPÄISCHE PATENTSCHRIFT

(11) **EP 1 101 277 B1**
(45) Veröffentlichungstag und Bekanntmachung des Hinweises auf die Patenterteilung: **05.11.2003**
(21) Anmeldenummer: 99947197.2
(22) Anmeldetag: 12.07.1999
(51) Int. Cl.: H02M 7/00

(54) **NIEDERINDUKTIVE VERSCHIENUNG FÜR EINEN DREIPUNKT-PHASENBAUSTEIN**
PROVISION OF A LOW-INDUCTIVE RAIL FOR A THREE-POINT PHASE MODULE
SYSTEME DE BARRES CONDUCTRICES A BASSE INDUCTION POUR MODULE DE PHASE A TROIS POINTS

(30) Priorität: 24.07.1998 DE 19833491
(43) Veröffentlichungstag der Anmeldung: 23.05.2001
(73) Patentinhaber: SIEMENS AKTIENGESELLSCHAFT, 80333 München (DE)
(72) Erfinder: BRUCKMANN, Manfred, D-90475 Nürnberg (DE); PFAUSER, Anton, D-96178 Pommersfelden (DE); GREIF, Tomas, D-91341 Röttenbach (DE)
(86) Internationale Anmeldenummer: DE9902149
(87) Internationale Veröffentlichungsnummer: WO00007288

(56) Entgegenhaltungen:
- WO-A1-94/08387
- WO-A1-97/13316
- DE-A1- 4 402 425
- US-A- 5 132 896
- US-A- 5 528 073
- US-A- 5 574 312

## Beschreibung

Die Erfindung bezieht sich auf eine niederinduktive Verschienung für einen Dreipunkt-Phasenbaustein mit der Reihenschaltzahl Eins und größer und auf eine niederinduktive Verschienung für einen mehrphasigen Dreipunkt-Stromrichter mit mehreren niederinduktiven Verschienungen für einen Dreipunkt-Phasenbaustein.

Bei Stromrichtern, die als Schalter schnellschaltende abschaltbare Leistungshalbleiterschalter, beispielsweise **I**nsulated-**G**ate-**B**ipolar-**T**ransistor (IGBT) verwenden, muß darauf geachtet werden, daß der Wert der Streuinduktivität der Verbindungen zwischen diesen abschaltbaren Leistungshalbleiterschaltern und den Zwischenkreiskondensatoren minimiert wird. Hierdurch werden die Spannungsspitzen sowohl beim Einschalten als auch beim Abschalten der Leistungshalbleiterschalter begrenzt, um eine höhere Beanspruchung oder sogar eine Zerstörung der Leistungshalbleiterschalter zu vermeiden. Zur Minimierung der Streuinduktivität werden die Verbindungen und die Zuleitungen als Verschienung ausgeführt.

Eine niederinduktive Verschienung für einen Zweipunkt-Stromrichter mit schnellschaltenden abschaltbaren Leistungshalbleiterschaltern weist zwei planparallel geführte Stromschienen auf, die mittels einer Isolierschicht voneinander elektrisch isoliert sind. Der Strom in diesen beiden Stromschienen muß gegenläufig fließen, damit die Streuinduktivität dieser Verschienung minimal wird. Als Stromschienen werden im Allgemeinen entsprechend ausgestaltete Kupferplatten verwendet. Der Abstand der beiden Stromschienen wird von der Isolierschicht bestimmt, wobei deren Dicke von der Spannungsbelastung abhängig ist. Die Flächen der Stromschienen, die sich bei der Stromführung überlappen, sollten maximal sein, wobei die Gesamtkonstruktion des Stromrichters dafür eine natürliche Grenze bildet. Verschiedene Design-Vorschläge für einen Zweipunkt-Wechselrichter wurde auf dem World Sales Meeting der Firm eupec von Herrn Dr. Schütze am 09. März 1997 vorgestellt.

Im Vortrag "IGBT-Wechselrichter für Antriebe in Industrie und Verkehr" von Dr. Salama und Dr. Tadros, abgedruckt in ETG-Fachbericht 39 (Vorträge der ETG-Fachtagung vom 13. Und 14. Mai 1992 in Bad Nauheim), Seiten 281 bis 295, wird als niederinduktive Verschienung eines IGBT-Dreipunkt-Wechselrichters eine Multilayertechnik verwendet, die alle Verbindungen und Zuleitungen innerhalb des Leistungsteils aufweist. Gemäß dem Bild 4 dieses Fachvortrages handelt es sich dabei um eine fünflagige Leiterführung. Ein derartiger Multilayer ist kompakt und ist gleichzeitig eine Trägerplatte für Beschaltungs- bzw. Zwischenkreiskondensatoren und für die Ansteuereinheiten der einzelnen schnellschaltenden, abschaltbaren Leistungshalbleiterschalter. In Abhängigkeit der verwendeten Eingangs-Gleichspannung des IGBT-Wechselrichters steigt die Anzahl der Lager des Multilayers und damit auch der Aufwand für die Erstellung eines solchen Multilayers. Ein weiterer wesentlicher Nachteil dieser Verschienungstechnik liegt in den Kosten des Multilayers.

Im Störungsfall, beispielsweise ein Defekt an einem der zwölf IGBTs bzw. an einem der 14 Dioden, ist der Aufwand für den Austausch eines IGBTs bzw. einer Diode sehr aufwendig, da der gesamte Dreipunkt-Wechselrichter demontiert werden muß. Ein weiterer Nachteil dieses Multilayers besteht darin, daß, wenn ein Leitungsbruch in einer Leiterebene auftritt, der gesamte Multilayer gegen einen neuen ausgetauscht werden muß. Auch dieser Vorgang ist arbeitsintensiv und zeitaufwendig. Außerdem ist ein hergestellter Multilayer nur für eine Ausführungsform eines IGBT-Wechselrichters verwendbar. Sollen für einen Schalter des Dreipunkt-Wechselrichters anstelle eines IGBTs wegen der höheren Eingangs-Gleichspannung nun zwei oder drei elektrisch in Reihe geschaltete IGBTs verwendet werden, so muß ein ganz neuer Multilayer entwickelt werden, bei dem sich zumindest die Anzahl der Leiterebenen ebenfalls erhöht. Das heißt, für einen Dreipunkt-Wechselrichter mit Reihenschaltzahl Eins, Zwei oder Drei werden unterschiedliche Multilayer benötigt.

Aus der WO 94/08387 A1 ist ein niederinduktives Verschienungssystem für einen 3-Punkt-Wechselrichter bekannt. Dieses niederinduktive Verschienungssystem weist eine Hauptverbindungsschiene und mehrere Nebenverbindungsschienen auf. Diese Nebenverbindungsschienen kreuzen rechtwinklig die Hauptverbindungsschiene, die mit mehreren Gruppen von Einzelkondensatoren elektrisch leitend verbunden ist. Somit liegt an dieser Hauptverbindungsschiene eine Gleichspannungsquelle mit den Potentialen + und - sowie das 0-Potential an. Die Haupt- und die Nebenverbindungsschienen sind mehrlagig ausgeführt und in Hochkantstellung angeordnet. Die Nebenverbindungsschienen verbinden jeweils die Halbleiter-Ventilelemente eines jeden Wechselrichterzweigpaares des 3-Punkt-Wechselrichters. Jedes Wechselrichterzweigpaar ist ebenfalls mit den drei Potentialen der Gleichspannungsquelle verbunden. Die elektrische Verbindung der Wechselrichterzweigpaare mit der Gleichspannungsquelle erfolgt jeweils durch einen Kreuzungspunkt einer jeden Nebenverbindungsschiene mit der Hauptverbindungsschiene. Diese vertikale Ausrichtung des niederinduktiven Verschienungssystems eines 3-Punkt-Wechselrichters ermöglicht eine leichte Zugänglichkeit für einen problemlosen Austausch von Halbleiter-Ventilelementen.

Der Erfindung liegt nun die Aufgabe zugrunde, eine niederinduktive Verschienung für einen Dreipunkt-Phasenbaustein eines mehrphasigen Dreipunkt-Stromrichters anzugeben, der eine geringe Lagenzahl aufweist und einfach erweiterbar ist.

Diese Aufgabe wird erfindungsgemäß gelöst mit den Merkmalen des Anspruchs 1.

Dadurch, daß die einzelnen unterschiedlichen Stromschienen eines Dreipunkt-Phasenbausteins auf drei Stromschienenebenen der induktiven Verschienung aufteilt sind, die untereinander jeweils mittels Isolationslagen voneinander elektrisch isoliert und planparallel angeordnet sind, erhält man eine kompakte niederinduktive Verschienung, die nur drei Stromschienenebenen aufweist. Wird bei einem Dreipunkt-Phasenbaustein für jeweils einen Schalter anstelle eines Halbleiterschalters zwei oder drei Halbleiterschalter verwendet, so können zusätzliche Stromschienen des Dreipunkt-Phasenbausteins mit einer Reihenschaltzahl größer Eins in wenigstens einer Stromschienenebene angeordnet werden. Somit weist die erfindungsgemäße niederinduktive Verschienung weiterhin nur drei Stromschienenebenen auf, wobei jedoch die Anzahl der Stromschienen innerhalb der Stromschienenebenen ansteigt.

Bei einer Ausführungsform der niederinduktiven Verschienung für einen Dreipunkt-Phasenbaustein mit der Reihenschaltzahl Eins sind eine Lastanschluß-Stromschiene, eine positive und eine negative Zwischenkreisanschluß-Stromschiene in einer Stromschienenebene, eine Verzweigungs-Stromschiene in einer nächsten Stromschienenebene und eine Mittelpunktsanschluß-Stromschiene in einer weiteren Stromschienenebene angeordnet.

Die Anordnung dieser drei Stromschienenebenen zueinander ist beliebig, wobei eine Anordnung, bei der die Stromschienenebene mit der Mittelpunktsanschluß-Stromschiene als eine äußere Stromschienenebene verwendet wird, besonders vorteilhaft ist.

Werden für jeden Schalter des Dreipunkt-Phasenbausteins anstelle eines Halbleiterschalters zwei oder drei Halbleiterschalter verwendet (Reihenschaltzahl Zwei oder Drei), so weist ein derartiger Dreipunkt-Phasenbaustein auch noch verbindungs-Stromschienen auf, die in einer Stromschienenebene der niederinduktiven Verschienung angeordnet werden, wobei die Verzweigungs-Stromschienen vorteilhafterweise in der Stromschienenebene angeordnet werden, die bereits die Lastanschluß-Stromschiene und eine positive und negative Zwischenkreisanschluß-Stromschiene aufweist. Durch diese Aufteilung der verschiedenen Stromschienen eines Dreipunkt-Phasenbausteins auf drei Stromschienenebenen kann auf einfache Weise die Verschienung an den elektrischen Aufbau des Phasenbausteins angepaßt werden.

Beispielsweise werden bei der Erhöhung der verwendeten Halbleiterschalter von zwei auf drei pro Schalter des Dreipunkt-Phasenbausteins nur sechs weitere Verbindungs-Stromschienen benötigt, die zusätzlich in der entsprechenden Stromschienenebene angeordnet werden. Da bei der Erhöhung der Anzahl der Halbleiterschalter pro Schalter des Dreipunkt-Phasenbausteins die räumliche Ausdehnung dieses Dreipunkt-Phasenbausteins ansteigt, ist ausreichend Platz in der entsprechenden Stromschienenebene für die Aufnahme weiterer Verbindungsstromschienen vorhanden.

Bei weiteren vorteilhaften Ausführungsform der niederinduktiven Verschienung für einen Dreipunkt-Phasenbaustein ist die Mittelpunktsanschluß-Stromschiene derart ausgebildet, daß diese die Stromschienen der beiden anderen Stromschienenebene abdeckt. Durch diese Ausgestaltung der Mittelpunktsanschluß-Stromschiene wird der Wert der Streuinduktivität weiter verringert.

Bei einer weiteren vorteilhaften Ausführungsform der niederinduktiven Verschienung für einen Dreipunkt-Phasenbaustein ist die Mittelpunktsanschluß-Stromschiene derart ausgebildet, daß die Anschlußfahnen der Zwischenkreisanschluß-Stromschienen ebenfalls abgedeckt werden. Durch diese Ausführungsform der Mittelpunktsanschluß-Stromschiene wird der Wert der Streuinduktivität noch weiter verringert.

Bei einer-weiteren vorteilhaften Ausführungsform der niederinduktiven Verschienung sind die Stromschienen der drei Stromschienenebenen miteinander verklebt. Somit erhält man eine kompakte Bauform für die Verschienung, so daß der Montageaufwand für einen Dreipunkt-Phasenbaustein sich erheblich verringert und vereinfacht. Außerdem übernehmen die Verklebungsschichten die Aufgabe der Isolation zwischen benachbarten Stromschienenebenen.

Bei einer weiteren vorteilhaften Ausführungsform der niederinduktiven Verschienung für einen Dreipunkt-Phasenbaustein sind die Verbindungs-Stromschienen einheitlich ausgestaltet. Dadurch kann der vorhandene Platz einer Stromschienenebene flächenmäßig optimal ausgenutzt werden. Außerdem vereinfacht sich die Lagerhaltung der Stromschienen und die Montage der niederinduktiven Verschienung.

Bei einer weiteren vorteilhaften Ausführungsform der niederinduktiven Verschienung für einen Dreipunkt-Phasenbaustein sind die Verbindungs-Stromschienen der oberen bzw. unteren Brückenhälfte des Dreipunkt-Phasenbausteins jeweils räumlich in einer Reihe angeordnet, wobei diese räumlich nebeneinander angeordnet sind. Dadurch halbiert sich die Länge der niederinduktiven Verschienung, wodurch außerdem die Zwischenkreisanschluß- und die Lastanschluß-Stromschiene räumlich gegenüber in einer Stromschienenebene angeordnet werden können.

Weitere vorteilhafte Ausgestaltungen der einzelnen Stromschienenebenen und der Stromschienen sind den Unteransprüchen 7 bis 14 zu entnehmen.

Durch diese erfindungsgemäße Ausgestaltung einer niederinduktiven Verschienung für einen Dreipunkt-Phasenbaustein besteht nun die Möglichkeit, drei derartige niederinduktiven Verschienungen mittels eines zweilagigen Zwischenkreis-Stromschienensystems zu einer niederinduktiven Verschienung für einen mehrphasigen Dreipunkt-Stromrichter ohne großen Aufwand zu vereinigen.

Zur näheren Erläuterung der Erfindung wird auf die Zeichnung Bezug genommen, in der zwei Ausführungsformen einer niederinduktiven Verschienung für einen Dreipunkt-Phasenbaustein schematisch veranschaulicht sind.
- FIG 1: zeigt ein Ersatzschaltbild eines Brückenzweiges eines Dreipunkt-Phasenbausteins mit einem abschaltbaren Halbleiterschalter pro Schalter (Reihenschaltzahl Eins), in der
- FIG 2: ist eine Draufsicht auf eine Stromschienenebene der erfindungsgemäßen niederinduktiven Verschienung dargestellt für einen Dreipunkt-Phasenbaustein nach FIG 1, in der
- FIG 3: ist eine Draufsicht auf eine nächste Stromschienenebene dieser erfindungsgemäßen niederinduktiven Verschienung veranschaulicht, wobei die
- FIG 4: eine Draufsicht auf eine erste Variante seiner weiteren Stromschienenebene zeigt und die
- FIG 5: eine zweite Variante dieser weiteren Stromschienenebene darstellt, die
- FIG 6: zeigt ein Ersatzschaltbild eines Brückenzweiges eines Dreipunkt-Phasenbausteins mit zwei abschaltbaren Halbleiterschalter pro Schalter (Reihenschaltzahl Zwei), wobei in

- FIG 7: eine Stromschienen-Anordnung einer Stromschienenebene einer erfindungsgemäßen niederinduktiven Verschienung für einen Dreipunkt-Phasenbaustein nach FIG 6 dargestellt ist, die
- FIG 8: zeigt die zugehörige Stromschienen-Anordnung einer nächsten Stromschienenebene, wogegen in der
- FIG 9: die Stromschienen-Anordnung einer zugehörigen weite- ren Stromschienenebene dargestellt ist, die
- FIG 10: zeigt eine verklebte niederinduktive Verschienung für einen Dreipunkt-Phasenbaustein gemäß FIG 6, die
- FIG 11: zeigt ein Ersatzschaltbild eines Brückenzweiges eines Dreipunkt-Phasenbausteins mit drei abschaltbaren Halbleiterschaltern pro Schalter (Reihenschaltzahl Drei), in der
- FIG 12: ist eine niederinduktive Verschienung für einen drei- phasigen Dreipunkt-Stromrichter dargestellt und die
- FIG 13: zeigt eine Rahmenkonstruktion eines Dreipunkt-Stromrichters mit der niederinduktiven Verschienung gemäß FIG 12.

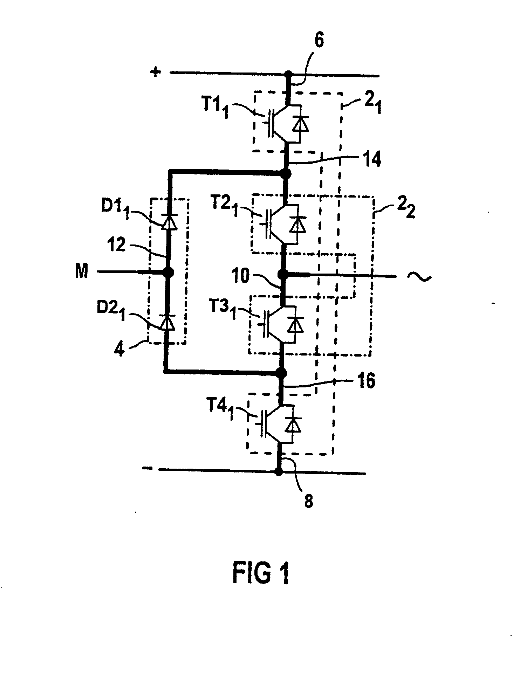

Die FIG 1 zeigt ein Ersatzschaltbild eines Brückenzweiges eines Dreipunkt-Phasenbausteins, der jeweils einen Halbleiterschalter T1₁, T2₁, T3₁ und T4₁ pro Schalter des Brückenzweiges und zwei Mittelpunktsdioden D1₁ und D2₁ aufweist. Die Halbleiterschalter T1₁, T4₁ und T2₁, T3₁ sind jeweils räumlich nebeneinander angeordnet. Dies ist jeweils durch eine unterbrochene Linie 2₁ und 2₂ veranschaulicht. Die beiden Mittelpunktsdioden D1₁ und D2₁ sind hier in einem Modulgehäuse untergebracht, was durch eine Strich-Punkt-Linie 4 veranschaulicht ist. Die Stromschienen dieses Dreipunkt-Phasenbausteins sind ihrer Funktion nach unterschiedlich bezeichnet. Mit 6 bzw. 8 ist eine positive bzw. negative Zwischenkreisanschluß-Stromschiene, mit 10 ist eine Lastanschluß-Stromschiene, mit 12 ist eine Mittelpunktsanschluß-Stromschiene und mit 14 bzw. 16 ist eine Verzweigungs-Stromschiene bezeichnet. Zur besseren Darstellung der elektrischen Verbindungen bzw. Zuleitungen als Stromschienen sind diese jeweils breiter dargestellt.

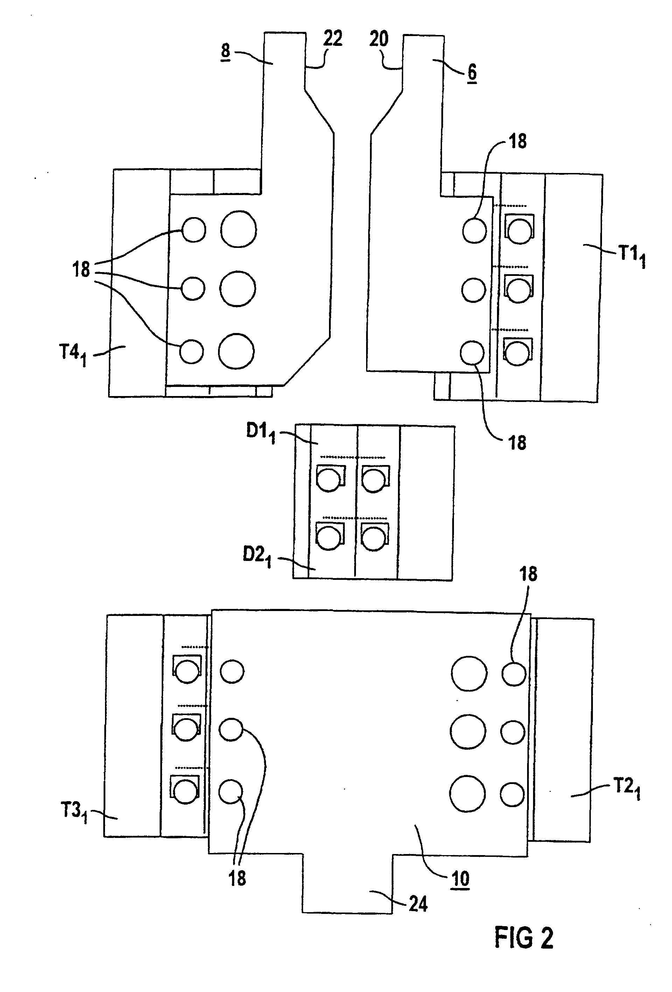

In der FIG 2 ist eine Draufsicht auf eine Stromschienenebene der erfindungsgemäßen niederinduktiven Verschienung für einen Dreipunkt-Phasenbaustein gemäß FIG 1 näher dargestellt. In dieser Stromschienenebene sind die beiden Zwischenkreisanschluß-Stromschienen 6 und 8 und die Lastanschluß-Stromschienen 10 angeordnet. Dabei sind die beiden Zwischenkreisanschluß-Stromschienen 6 und 8 nebeneinander angeordnet und die Lastanschluß-Stromschiene 10 diesen beiden Zwischenkreisanschluß-Stromschienen 6 und 8 beabstandet räumlich gegenüber angeordnet. Diese drei Stromschienen 6, 8 und 10 sind jeweils mit zu den zugehörigen Halbleiterschaltern T1₁, T4₁, T2₁ und T3₁ korrespondierenden Bohrungen 18 versehen und weisen jeweils eine Anschlußfahne 20, 22 und 24 auf. Die jeweiligen Anschlußfahnen 20 und 22 der positiven und negativen Zwischenkreisanschluß-Stromschienen 6 und 8 sind derart ausgebildet, daß zwischen diesen beiden Anschlußfahnen 20 und 22 kein Spannungsdurchbruch auftreten kann. Ebenso ist der Teil der negativen Zwischenkreisanschluß-Stromschiene 8 gegenüber der Mittelpunktsdiode D1₁ ausgestaltet, wodurch die Kriechstrecke zwischen den Eckspitzen der beiden Zwischenkreisanschluß-Stromschienen 6 und 8 vergrößert ist.

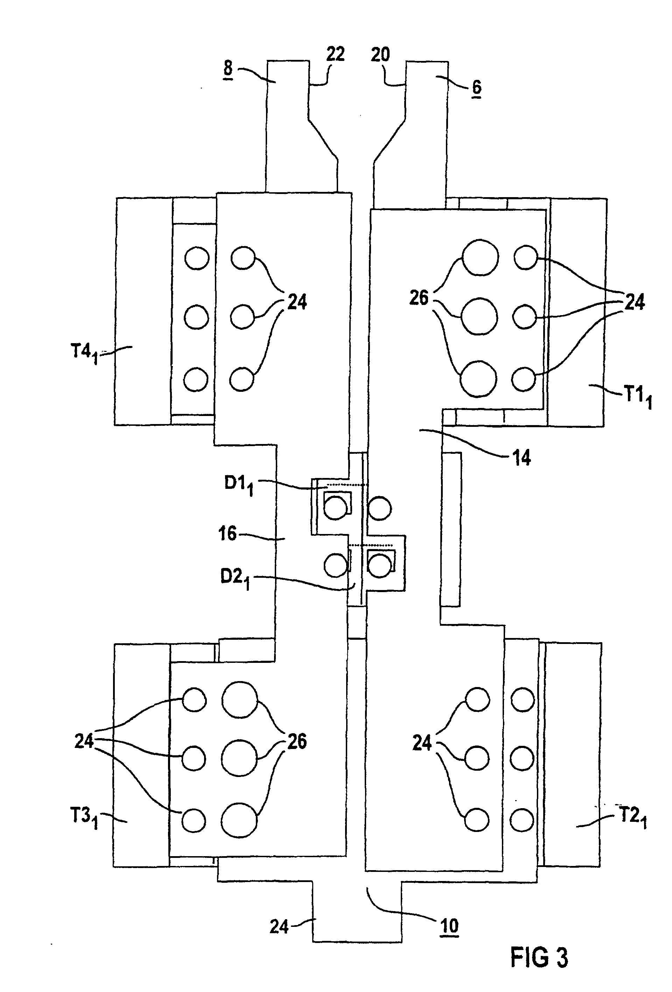

Die FIG 3 zeigt nun eine Draufsicht auf eine nächste Stromschienenebene der erfindungsgemäßen niederinduktiven Verschienung für einen Dreipunkt-Phasenbaustein gemäß FIG 1. In dieser Stromschienenebene sind die beiden Verzweigungs-Stromschienen 14 und 16 dargestellt. Die Verzweigungs-Stromschienen 14 bzw. 16 verbindet den äußeren Halbleiterschalter T1₁ bzw. T4₁ mit dem inneren Halbleiterschalter T2₁ bzw. T3₁ der oberen bzw. unteren Brückenhälfte des Brückenzweiges des Dreipunkt-Phasenbausteins. In dieser Darstellung wird ebenfalls die Mittelpunktsdiode D1₁ bzw. D2₁ mit der Verzweigungs-Stromschiene 14 bzw. 16 elektrisch leitend verbunden. Die Verzweigungs-Stromschiene 14 bzw. 16 weist jeweils für die andere Mittelpunktsdiode D2₁ bzw. D1₁ eine Ausnehmung auf, die derart ausgeformt ist, daß die Diode D1₁ bzw. D2₁ nicht kurzgeschlossen wird. Auch diese Verzweigungs-Stromschienen 14 und 16 weisen jeweils in ihren Anschlußbereichen zu den zugehörigen Halbleiterschaltern T1₁, T2₁ und T4₁, T3₁ korrespondierende Bohrungen 24 auf. Korrespondierend zu den Bohrungen 18 der Stromschienen 6, 8 und 10 der Stromschienenebene gemäß FIG 2 weisen die Stromschienen 14 und 16 der zweiten Stromschienenebene Ausnehmungen 26 auf. Diese Ausnehmungen 26 sind derart ausgebildet, daß deren Durchmesser wesentlich größer sind als die Durchmesser der Bohrungen 18 bzw. 24. Bei einer besonderen Ausgestaltung der Verbindungs-Stromschienen 14 und 16 sind diese Ausnehmungen 26 mit einem Isolierring versehen. Die Stromschienen 8 und 10 der Stromschienenebene gemäß FIG 2 weisen ebenfalls entsprechende Ausnehmungen korrespondierend zu den Bohrungen 24 der Stromschienen 14 und 16 der zweiten Stromschinenebene auf.

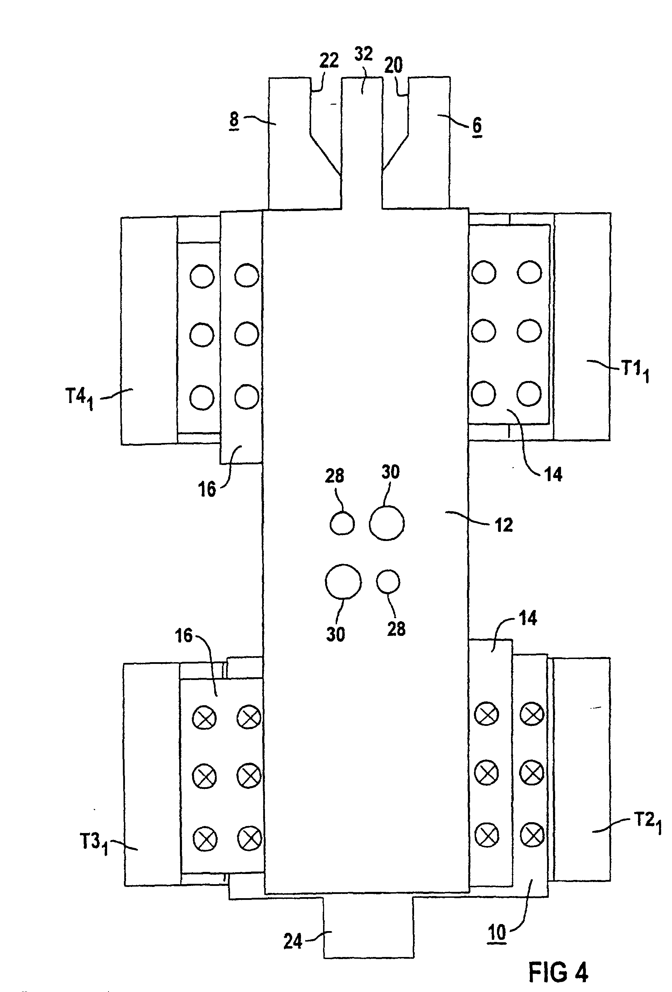

In der FIG 4 ist eine Draufsicht auf eine weitere Stromschienenebene dargestellt. Diese weitere Stromschienenebene weist nur eine Mittelpunktsanschluß-Stromschiene 12 auf. Diese Mittelpunktsanschluß-Stromschiene 12 weist zwei Bohrungen 28 und zwei Ausnehmungen 30 auf. Die Ausnehmungen 30 sind entsprechend den Ausnehmungen 26 der Stromschienen 14 und 16 der Stromschienenebene gemäß FIG 3 ausgestaltet. Die Bohrung 28 dieser Mittelpunktsanschluß-Stromschiene 12 sind dafür vorgesehen, die Mittelpunktsdioden D1₁ und D2₁ mit einem Mittelpunktsanschluß M des Dreipunkt-Phasenbausteins elektrisch leitend zu verbinden. Außerdem weist diese Mittelpunktsanschluß-Stromschiene 12 eine Anschlußfahne 32 auf, die zwischen den Anschlußfahnen 20 und 22 der positiven und negativen Zwischenkreisanschluß-Stromschiene 6 und 8 ragt. Da diese Mittelpunktsanschluß-Stromschiene 12 die anderen beiden Stromschienenebenen mit Ausnahme der Anschlußbereiche abdeckt, ist der Wert der Streuinduktivität für diese Verschienung niedrig.

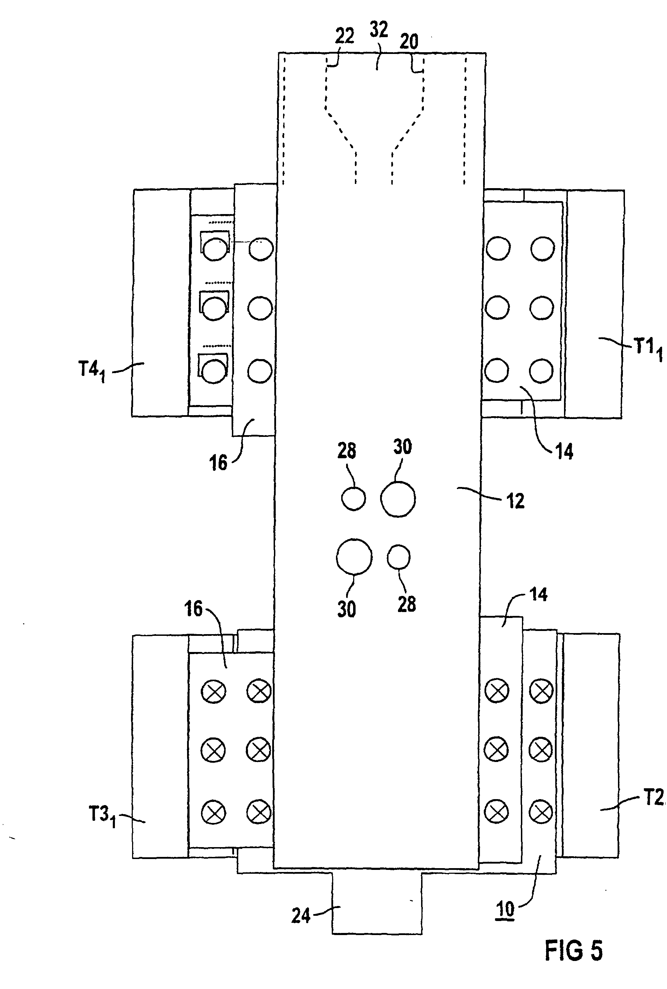

Die FIG 5 zeigt eine zweite Variante der Mittelpunktsanschluß-Stromschiene 12. Diese Variante ist dadurch gekennzeichnet, daß die Anschlußfahne 32 der Mitteipunktsanschluß-Stromschiene 12 derart ausgebildet ist, daß die Anschlußfahnen 20 und 22 der beiden Zwischenkreisanschluß-Stromschienen 6 und 8 abgedeckt werden. Dadurch wird der Wert der Streuinduktivität dieser Verschienung noch weiter verringert.

Wie bei dem eingangs genannten zweilagigen Stromschienensystem sind ebenfalls zwischen den Stromschienenebenen jeweils Isolierlagen angeordnet. In einer besonders vorteilhaften Ausführungsform der niederinduktiven Verschienung sind die Stromschienen der einzelnen Stromschienenebenen miteinander verklebt, so daß die Verschienung als ganzes beim Aufbau eines Dreipunkt-Phasenbaustein verwendet werden kann. Dadurch vereinfacht sich die Montage wesentlich.

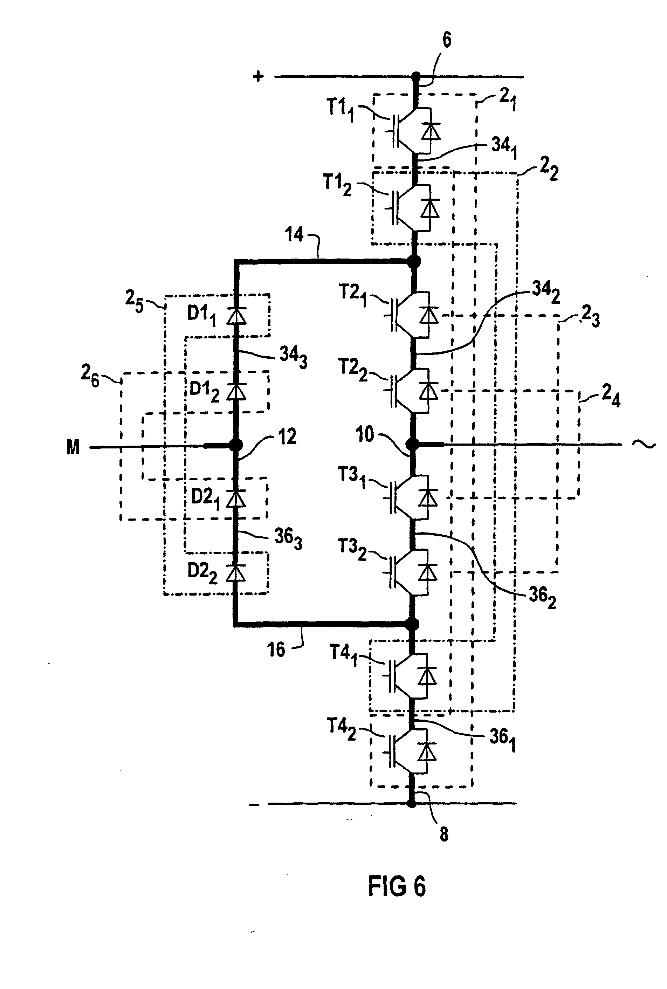

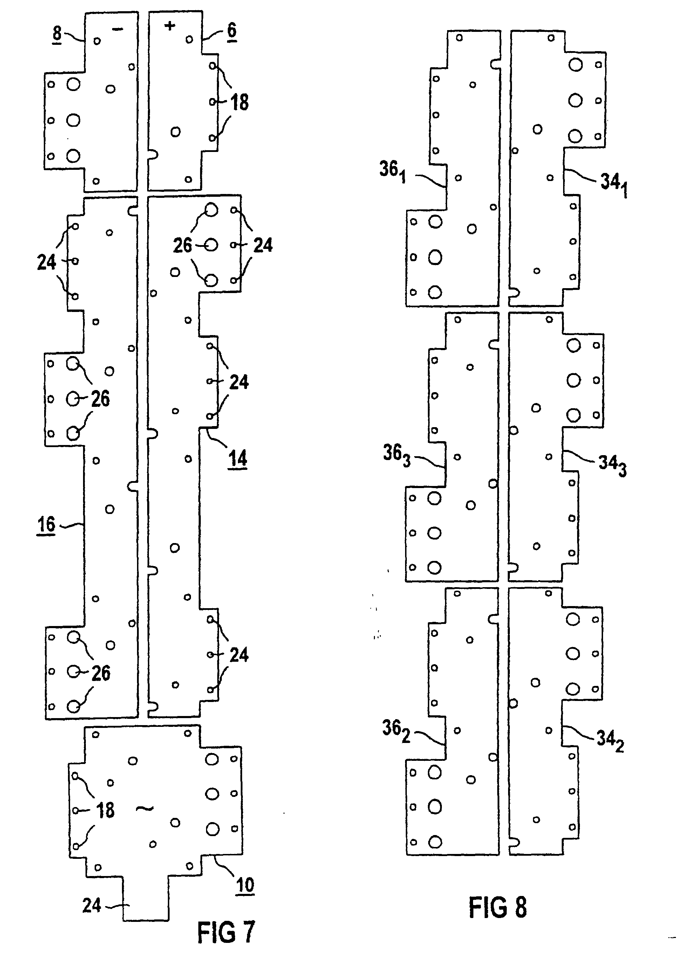

Die FIG 6 zeigt ein Ersatzschaltbild eines Brückenzweiges eines Dreipunkt-Phasenbausteins, der zwei Halbleiterschalter T1_{1,2}, T2_{1,2}, T3_{1,2} und T4_{1,2} pro Schalter des Brückenzweiges und zwei Mittelpunktsdioden D1_{1,2} und D2_{1,2} aufweist (Reihenschaltzahl Zwei). Da bei den Phasenbausteinen mit der Reihenschaltzahl Zwei pro Schalter ein zweiter Halbleiterschalter T1₂, T2₂, T3₂ und T4₂ und pro Mittelpunktsdiode eine zweite Diode D1₂ und D2₂ hinzugekommen sind, kommen zu den Verzweigungs-Stromschienen 14 und 16 sechs Verbindungsschienen 34₁, 34₂, 34₃, 36₁, 36₂ und 36₃ hinzu. In dieser Ausführungsform sind die beiden Verzweigungs-Stromschienen 14 und 16 nicht in der Stromschienenebene gemäß FIG 3, sondern in der Stromschienenebene gemäß FIG 2 angeordnet. Diese beiden Verzweigungs-Stromschienen 14 und 16 sind räumlich zwischen den Zwischenkreisanschluß-Stromschienen 6 und 8 und der Lastanschluß-Stromschiene 10 in dieser Stromschienenebene gemäß FIG 1 an-geordnet. In der FIG 7 ist die Anordnung der Stromschienen 6, 8, 10 und 14, 16 in einer Stromschienenebene näher dargestellt.

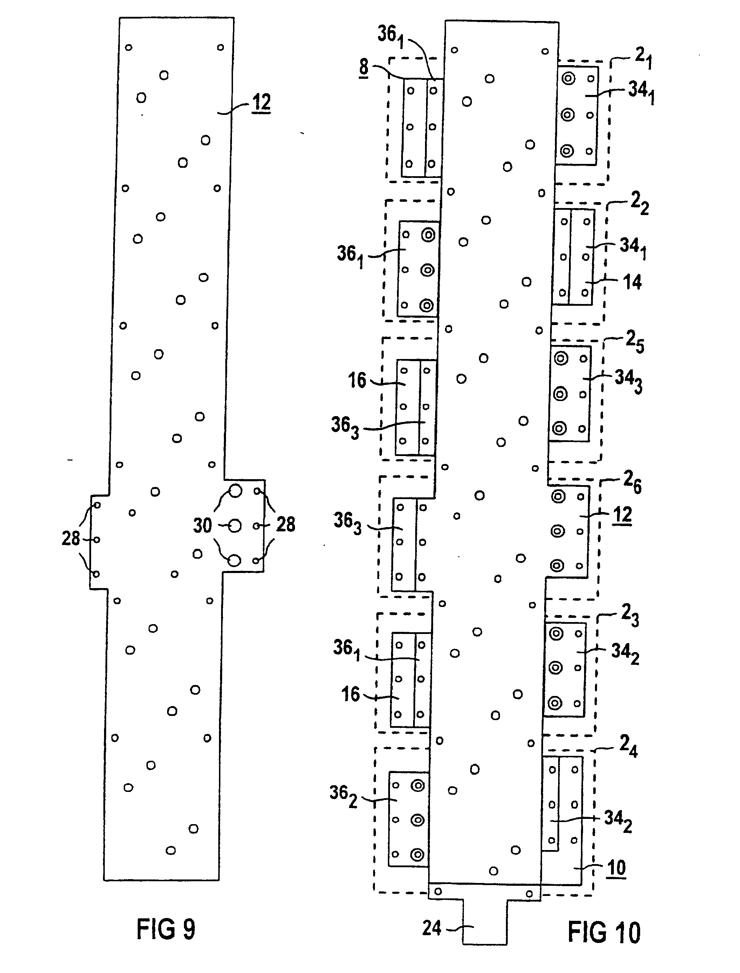

Die nächste Stromschienenebene weist nur noch Verbindungs-Stromschienen 34_{1,2,3} und 36_{1,2,3} auf, die jeweils in zwei nebeneinander verlaufenden Reihen angeordnet sind (FIG 3). Dabei sind die Verbindungs-Stromschienen 34_{1,2,3} und 36_{1,2,3} alle gleichgeformt. Die weitere Stromschienenebene weist wie beim Ausführungsbeispiel mit der Reihenschaltzahl Eins (FIG 1) nur eine Mittelpunktsanschluß-Stromschiene 12 auf (FIG 9).

In der FIG 10 ist eine verklebte niederinduktive Verschienung für einen Dreipunkt-Phasenbaustein mit einer Reihenschaltzahl Zwei dargestellt. Außerdem sind in dieser Figur mittels einer unterbrochenen Linie 2₁ bis 2₄ und 2₅, 2₆ jeweils die Lage der Halbleiterschalter T1₁, T4₂; T1₂, T4₁; T2₁, T3₂; T2₂, T31 und jeweils die Lage der Mittelpunktsdioden D1₁, D2₂ und D1₂, D2₁ des Dreipunkt-Phasenbausteins nach FIG 6 veranschaulicht.

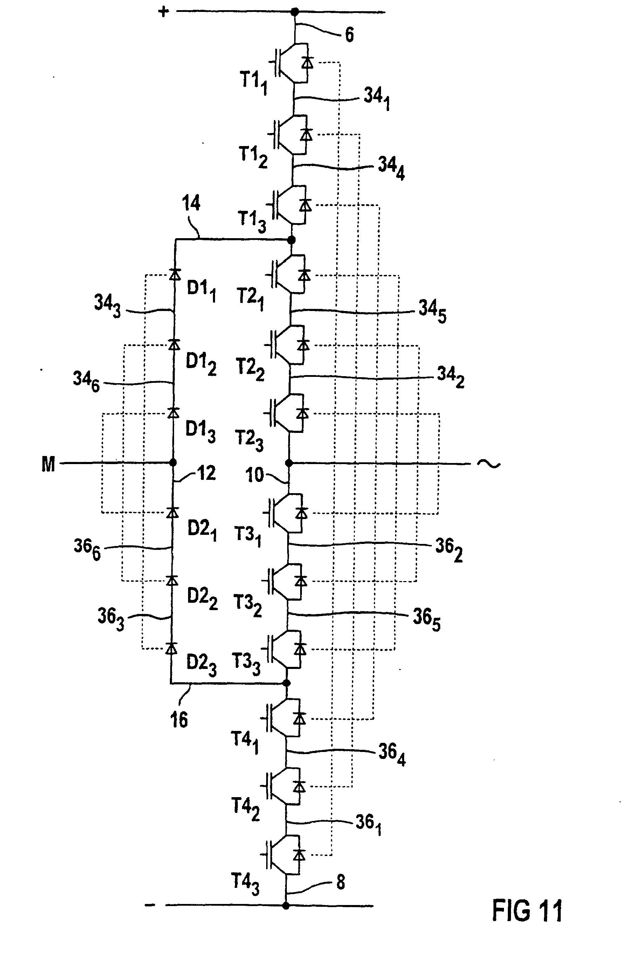

In der FIG 11 ist ein Ersatzschaltbild eines Brückenzweiges eines Dreipunkt-Phasenbausteins mit einer Reihenschaltzahl Drei dargestellt. Die Reihenschaltzahl Drei besagt, daß pro Schalter eines Dreipunkt-Brückenzweiges drei elektrisch in Reihe geschaltete Halbleiterschalter T1_{1,2,3}, T2_{1,2,3}, T3_{1,2,3} und T4_{1,2,3} verwendet werden. Ein Vergleich mit dem Ersatzschaltbild gemäß FIG 6 zeigt, daß pro Halbleiterbrücke drei weitere Verbindungs-Stromschienen 34₄, 34₅, 34₆ und 36₄, 36₅, 36₆ hinzugekommen sind. Das heißt, in der Stromschienenebene werden diese weiteren Verbindungs-Stromschienen 34_{4,5,6} und 36_{4,5,6} untergebracht. Durch die Hinzuführung von vier weiteren Halbleiterschaltern T1₃, T2₃, T3₃, T4₃ und zwei weiteren Mittelpunktsdioden D1₂ und D2₃ verlängert sich der räumliche Aufbau des Dreipunkt-Phasenbausteins, so daß in der Stromschienenebene, die die Verbindungs-Stromschienen 34_{1,2,3} und 36_{1,2,3} bereits aufweist, genügend Platz ist, um die weiteren Verbindungs-Stromschienen 34_{4,5,6} und 36_{4,5,6} aufnehmen zu können. Das heißt, die Anzahl der Stromschienenebenen der erfindungsgemäßen niederinduktiven Verschienung ist immer Drei und somit unabhängig von der Reihenschaltzahl des Dreipunkt-Phasenbausteins.

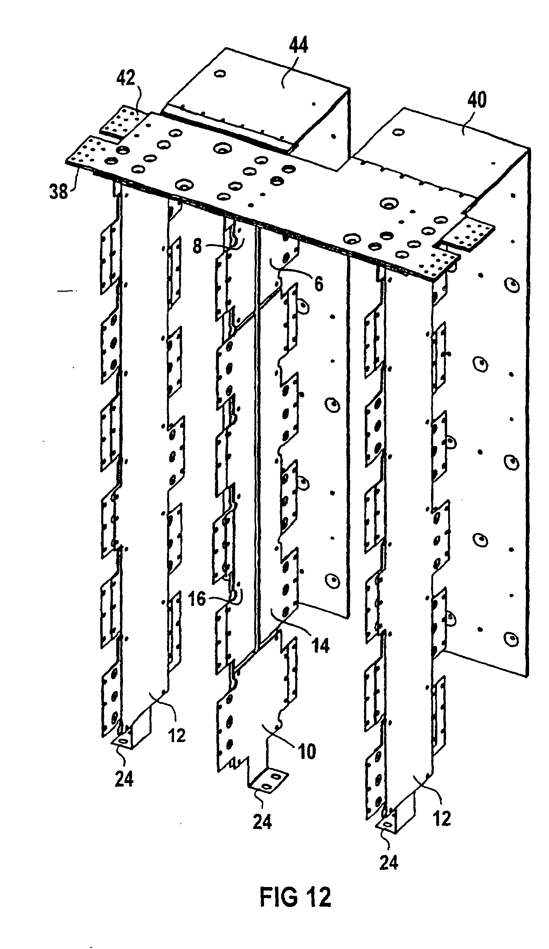

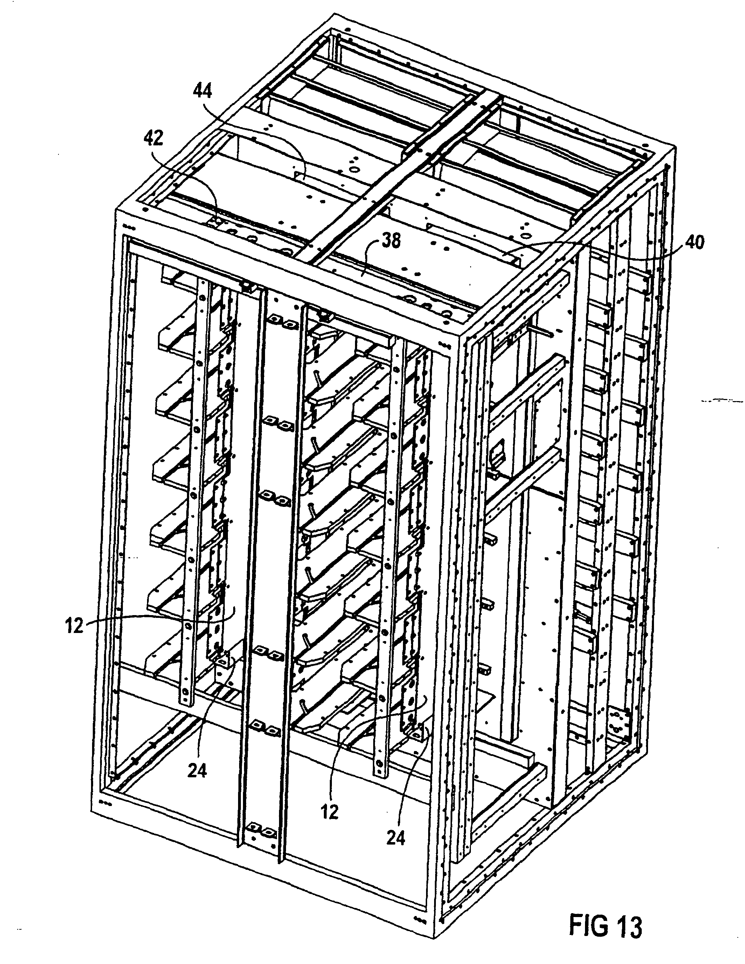

Die FIG 12 zeigt eine niederinduktive Verschienung für einen dreiphasigen Dreipunkt-Stromrichter, der für jeden Dreipunkt-Phasenbaustein eine niederinduktive Verschienung nach FIG 10 verwendet. Die positive Zwischenkreisanschluß-Stromschiene 6 der Phasenbaustein-Verschienungen sind mittels einer positiven Querstromschiene 38 mit einer positiven Zwischenkreis-Stromschiene 40 elektrisch leitend verbunden, wogegen die negative Zwischenkreisanschluß-Stromschiene 8 der Phasenbaustein-Verschienungen mittels einer negativen Querstromschiene 42 mit einer negativen Zwischenkreis-Stromschiene 44 elektrisch leitend verbunden sind. In der FIG 13 ist diese Verschienung für einen dreiphasigen Dreipunkt-Stromrichter in einer zugehörigen Rahmenkonstruktion dargestellt.

## Patentansprüche

1. Niederinduktive Verschienung eines Dreipunkt-Phasenbausteins in einem mehrphasigen Dreipunkt-Stromrichter, wobei für jeden Schalter dieses Dreipunkt-Phasenbausteins wenigstens ein abschaltbarer Halbleiterschalter (T1₁, T2₁, T3₁, T4₁; T1_{1,2}, T2_{1,2}, T3_{1,2}, T4_{1,2}; T1_{1,2,3}, T2_{1,2,3}, T3_{1,2,3}, T4_{1,2,3}) und für jede der beiden Mittelpunktsdioden wenigstens eine Diode (D1₁, D2₁; D1_{1,2}, D2_{1,2}; D1_{1,2,3}, D2_{1,2,3}) vorgesehen ist, wobei Anschluß-, Verzweigungs- und Verbindungs-Stromschienen (6, 8, 10, 12, 14, 16, 34, 36) dieses Dreipunkt-Phasenbausteins auf drei Stromschienenebenen der niederinduktiven Verschienung verteilt sind, die untereinander jeweils mittels Isolationslagen voneinander elektrisch isoliert und planparallel angeordnet sind.

2. Niederinduktive Verschienung nach Anspruch 1,
**dadurch gekennzeichnet,**
**daß** eine Mittelpunktsanschluß-Stromschiene (12) in einer Stromschienenebene angeordnet und derart ausgebildet ist, daß diese die Stromschienen (6, 8, 10, 14, 16, 34, 36) zweier weiterer Stromschienenebenen abdeckt.

3. Niederinduktive Verschienung nach Anspruch 1,
**dadurch gekennzeichnet,**
**daß** eine Mittelpunktsanschluß-Stromschiene (12) in einer Stromschienenebene derart ausgebildet ist, daß Anschlußfahnen (20,22) zweier Zwischenkreisanschluß-Stromschienen (6,8) abgedeckt werden.

4. Niederinduktive Verschienung nach einem der Ansprüche 1 bis 3,
**dadurch gekennzeichnet,**
**daß** die Stromschienen (6,8,10,12,14,16,34,36) der drei Stromschienenebenen miteinander verklebt sind.

5. Niederinduktive Verschienung nach einem der Ansprüche 1 bis 3,
**dadurch gekennzeichnet,**
**daß** die Verbindungs-Stromschienen (34, 36) identisch sind.

6. Niederinduktive Verschienung nach einem der Ansprüche 1 bis 5,
**dadurch gekennzeichnet,**
**daß** die Verbindungs-Stromschienen (34, 36) einer oberen bzw. unteren Brückenhälfte des Dreipunkt-Phasenbausteins räumlich jeweils in einer Reihe angeordnet sind, wobei diese räumlich nebeneinander angeordnet sind.

7. Niederinduktive Verschienung nach einem der Ansprüche 1 bis 6,
**dadurch gekennzeichnet,**
**daß** zwei der drei Stromschienenebenen mehrere Stromschienen (4, 6, 8, 10, 14, 16; 34, 36) aufweisen.

8. Niederinduktive Verschienung nach einem der Ansprüche 1 bis 7,
**dadurch gekennzeichnet,**
**daß** wenigstens eine Lastanschluß-Stromschiene (10) und eine positive und negative Zwischenkreisanschluß-Stromschiene (6, 8) in einer Stromschienenebene angeordnet sind.

9. Niederinduktive Verschienung nach einem der Ansprüche 1 bis 7,
**dadurch gekennzeichnet,**
**daß** Verbindungs-Stromschienen (34, 36) jeweils zweier elektrisch in Reihe geschalteter Bauelemente des Dreipunkt-Phasenbausteins in einer Stromschienenebene angeordnet sind.

10. Niederinduktive Verschienung nach einem der Ansprüche 1 bis 7,
**dadurch gekennzeichnet,**
**daß** eine Mittelpunktsanschluß-Stromschiene (12) in einer Stromschienenebene angeordnet ist.

11. Niederinduktive Verschienung nach einem der Ansprüche 1 bis 10,
**dadurch gekennzeichnet,**
**daß** in der Stromschienenebene, die die Anschluß-Stromschienen (6, 8, 10) aufweist, die Verzweigungs-Stromschienen (14, 16) angeordnet sind.

12. Niederinduktive Verschienung nach einem der Ansprüche 1 bis 11,
**dadurch gekennzeichnet,**
**daß** die Zwischenkreisanschluß-Stromschienen (6, 8) einer Stromschienenebene nebeneinander angeordnet sind.

13. Niederinduktive Verschienung nach einem der Ansprüche 1 bis 12,
**dadurch gekennzeichnet,**
**daß** die beiden Verzweigungs-Stromschienen (14, 16) räumlich nebeneinander und zwischen den Zwischenkreisanschluß-Stromschienen (4, 6) und der Lastanschluß-Stromschiene (10) angeordnet sind.

14. Niederinduktive Verschienung nach einem der vorgenannten Ansprüche,
**dadurch gekennzeichnet,**
**daß** jede Stromschiene (6, 8, 10, 12, 14, 16, 34, 36) jeder Stromschienenebene mit zu den Bauelementen des Dreipunkt-Phasenbausteins korrespondierende Bohrungen aufweist.

15. Niederinduktive Verschienung für eine mehrphasigen Dreipunkt-Stromrichter mit mehreren niederinduktiven Verschienungen nach einem der Ansprüche 1 bis 14, wobei eine positive und eine negative Zwischenkreisanschluß-Stromschiene (6, 8) jeweils einer induktiven Verschienung eines Phasenbausteins mittels einer positiven und negativen Querstromschiene (38, 42) mit einer positiven und einer negativen Zwischenkreis-Stromschiene (40, 44) elektrisch leitend verbunden sind.

## Claims

1. A low-inductive busbar arrangement of a three-point phase module in a polyphase three-point power converter, wherein at least one turn-off semiconductor switch (T1₁, T2₁, T3₁, T4₁; T1_{1,2}, T2_{1,2}, T3_{1,2}, T4_{1,2}; T1_{1,2,3}, T2_{1,2,3}, T3_{1,2,3}, T4_{1,2,3}) is provided for each switch of this three-point phase module and at least one diode (D1₁, D2₁; D1_{1,2}, D2_{1,2}; D1_{1,2,3}, D2_{1,2,3}) is provided for each of the neutral point diodes, and wherein terminal, branch and connection busbars (6, 8, 10, 12, 14, 16, 34, 36) of this three-point phase module are distributed between three busbar planes of the low-inductive busbar arrangement, said planes being mutually electrically isolated from one another by means of insulating layers and being arranged parallel to one another.

2. The low-inductive busbar arrangement according to claim 1,
**characterised in that**
a neutral point terminal busbar (12) is arranged in a busbar plane and is designed such that the busbar plane covers the busbars (6, 8, 10, 14, 16, 34, 36) of two further busbar planes.

3. The low-inductive busbar arrangement according to claim 1,
**characterised in that**
a neutral point terminal busbar (12) in a busbar plane is designed such that terminal lugs (20, 22) of two intermediate circuit terminal busbars (6, 8) are covered.

4. The low-inductive busbar arrangement according to one of the claims 1 to 3,
**characterised in that**
the busbars (6, 8, 10, 12, 14, 16, 34, 36) of the three busbar planes are adhesively bonded to one another.

5. The low-inductive busbar arrangement according to one of the claims 1 to 3,
**characterised in that**
the connection busbars (34, 36) are identical.

6. The low-inductive busbar arrangement according to one of the claims 1 to 5,
**characterised in that**
the connection busbars (34, 36) of an upper and lower bridge half of the three-point phase module are each arranged spatially in a row and are spatially adjacent to one another.

7. The low-inductive busbar arrangement according to one of the claims 1 to 6,
**characterised in that**
two of the three busbar planes have a plurality of busbars (4, 6, 8, 10, 14, 16; 34, 36).

8. The low-inductive busbar arrangement according to one of the claims 1 to 7,
**characterised in that**
at least one load terminal busbar (10) and a positive and negative intermediate circuit terminal busbar (6, 8) are arranged in one of the busbar planes.

9. The low-inductive busbar arrangement according to one of the claims 1 to 7,
**characterised in that**
connection busbars (34, 36) of two components of the three-point phase module in each case, said components being electrically connected in series to one another, are arranged in one of the busbar planes.

10. The low-inductive busbar arrangement according to one of the claims 1 to 7,
**characterised in that**
a neutral point terminal busbar (12) is arranged in one of the busbar planes.

11. The low-inductive busbar arrangement according to one of the claims 1 to 10,
**characterised in that**
the branch busbars (14, 16) are arranged in the busbar plane which has the terminal busbars (6, 8, 10).

12. The low-inductive busbar arrangement according to one of the claims 1 to 11,
**characterised in that**
the intermediate circuit terminal busbars (6, 8) of a busbar plane are arranged adjacent to one another.

13. The low-inductive busbar arrangement according to one of the claims 1 to 12,
**characterised in that**
the two branch busbars (14, 16) are arranged spatially adjacent to one another and are arranged between the intermediate circuit terminal busbars (4, 6) and the load terminal busbar (10).

14. The low-inductive busbar arrangement according to one of the preceding claims,
**characterised in that**
each busbar (6, 8, 10, 12, 14, 16, 34, 36) of each busbar plane has holes corresponding to the components of the three-point phase module.

15. A low-inductive busbar arrangement for a polyphase three-point power converter having a plurality of low-inductive busbar arrangements according to one of the claims 1 to 14,
wherein a positive and a negative intermediate circuit terminal busbar (6, 8) of an inductive busbar arrangement of a phase module in each case are electrically conductively connected to a positive and negative intermediate circuit busbar (40, 44) by means of a positive and negative shunt busbar (38, 42).

## Revendications

1. Système de barres conductrices à basse inductance d'un module de phase à trois points dans un convertisseur polyphasé à trois points, dans lequel il est prévu pour chaque commutateur de ce module de phase à trois points au moins un commutateur semi-conducteur interruptible (T1₁, T2₁, T3₁, T4₁ ; T1_{1,2}, T2_{1,2}, T3_{1,2}, T4_{1,2} ; T1_{1,2,3}, T2_{1,2,3}, T3_{1,2,3}, T4_{1,2,3}) et pour chacune des deux diodes de point central au moins une diode (D1₁, D2₁ ; D1_{1,2}, D2_{1,2} ; D1_{1,2,3}, D2_{1,2,3}) et dans lequel des barres conductrices de raccordement, de branchement et de liaison (6, 8, 10, 12, 14, 16, 34, 36) de ce module de phase à trois points sont réparties sur trois niveaux de barres conductrices du système de barres conductrices à basse inductance qui sont disposés en parallélépipède et isolés les uns des autres au moyen de couches isolantes.

2. Système de barres conductrices à basse inductance selon la revendication 1, **caractérisé par le fait qu'**une barre conductrice de raccordement de point central (12) est disposée dans un niveau de barres conductrices et est conçue de telle sorte qu'elle couvre les barres conductrices (6, 8, 10, 14, 16, 34, 36) de deux autres niveaux de barres conductrices.

3. Système de barres conductrices à basse inductance selon la revendication 1, **caractérisé par le fait qu'**une barre conductrice de raccordement de point central (12) dans un niveau de barres conductrices est conçue de telle sorte que des barrettes (20, 22) de deux barres conductrices de raccordement de circuit intermédiaire (6, 8) sont couvertes.

4. Système de barres conductrices à basse inductance selon l'une des revendications 1 à 3, **caractérisé par le fait que** les barres conductrices (6, 8, 10, 12, 14, 16, 34, 36) des trois niveaux de barres conductrices sont collées entre elles.

5. Système de barres conductrices à basse inductance selon l'une des revendications 1 à 3, **caractérisé par le fait que** les barres conductrices de liaison (34, 36) sont identiques.

6. Système de barres conductrices à basse inductance selon l'une des revendications 1 à 5, **caractérisé par le fait que** les barres conductrices de liaison (34, 36) d'un demi-pont supérieur respectivement inférieur du module de phase à trois points sont disposées spatialement à chaque fois en une rangée, ces rangées étant disposées spatialement l'une à côté de l'autre.

7. Système de barres conductrices à basse inductance selon l'une des revendications 1 à 6, **caractérisé par le fait que** deux des trois niveaux de barres conductrices comportent plusieurs barres conductrices (6, 8, 10, 14, 16 ; 34, 36).

8. Système de barres conductrices à basse inductance selon l'une des revendications 1 à 7, **caractérisé par le fait qu'**au moins une barre conductrice de raccordement de charge (10) et une barre conductrice de raccordement de circuit intermédiaire positive (6) ainsi qu'une barre conductrice de raccordement de circuit intermédiaire négative (8) sont disposées dans un niveau de barres conductrices.

9. Système de barres conductrices à basse inductance selon l'une des revendications 1 à 7, **caractérisé par le fait que** des barres conductrices de liaison (34, 36) à chaque fois de deux composants, branchés électriquement en série, du module de phase à trois points sont disposées dans un niveau de barres conductrices.

10. Système de barres conductrices à basse inductance selon l'une des revendications 1 à 7, **caractérisé par le fait qu'**une barre conductrice de raccordement de point central (12) est disposée dans un niveau de barres conductrices.

11. Système de barres conductrices à basse inductance selon l'une des revendications 1 à 10, **caractérisé par le fait que** les barres conductrices de branchement (14, 16) sont disposées dans le niveau de barres conductrices qui comporte les barres conductrices de raccordement (6, 8, 10).

12. Système de barres conductrices à basse inductance selon l'une des revendications 1 à 11, **caractérisé par le fait que** les barres conductrices de raccordement de circuit intermédiaire (6, 8) d'un niveau de barres conductrices sont disposées l'une à côté de l'autre.

13. Système de barres conductrices à basse inductance selon l'une des revendications 1 à 12, **caractérisé par le fait que** les deux barres conductrices de branchement (14, 16) sont disposées l'une à côté de l'autre dans l'espace et entre les barres conductrices de raccordement de circuit intermédiaire (6,8) et la barre conductrice de raccordement de charge (10).

14. Système de barres conductrices à basse inductance selon l'une des revendications précédentes, **caractérisé par le fait que** chaque barre conductrice (6, 8, 10, 12, 14, 16, 34, 36) de chaque niveau de barres conductrices comporte des trous correspondant aux composants du module de phase à trois points.

15. Système de barres conductrices à basse inductance pour un convertisseur polyphasé à trois points comportant plusieurs systèmes de barres conductrices à basse inductance selon l'une des revendications 1 à 14, dans lequel une barre conductrice de raccordement de circuit intermédiaire positive (6) et une barre conductrice de raccordement de circuit intermédiaire négative (8) à chaque fois d'un système de barres conductrices à inductance d'un module de phase sont reliées de façon électriquement conductrice au moyen d'une barre conductrice transversale positive (38) respectivement d'une barre conductrice transversale négative (42) à une barre conductrice de circuit intermédiaire positive (40) respectivement une barre conductrice de circuit intermédiaire négative (44).
